(19) Europäisches Patentamt
European Patent Office
Office européen des brevets

(11) Publication number: **0 005 127**
**A2**

(12) # EUROPEAN PATENT APPLICATION

(21) Application number: 79830008.3

(22) Date of filing: 11.04.79

(51) Int. Cl.[2]: H 03 D 7/16
G 01 S 7/40, H 04 L 27/10

(30) Priority: 18.04.78 IT 4894578

(43) Date of publication of application:
31.10.79 Bulletin 79/22

(84) Designated Contracting States:
BE DE FR GB NL

(71) Applicant: SELENIA INDUSTRIE ELETTRONICHE ASSOCIATE S.p.A.
Via Tiburtina, KM 12.4
I-00131 Roma(IT)

(72) Inventor: Cerra, Raffaele
Via S. Domenico 29
I-80127 Napoli(IT)

(54) **Improvement in systems of frequency translation of frequency-modulated signals.**

(57) This invention is concerned with a method of frequency translation of frequency-modulated signals by means of two phase-locked loops.

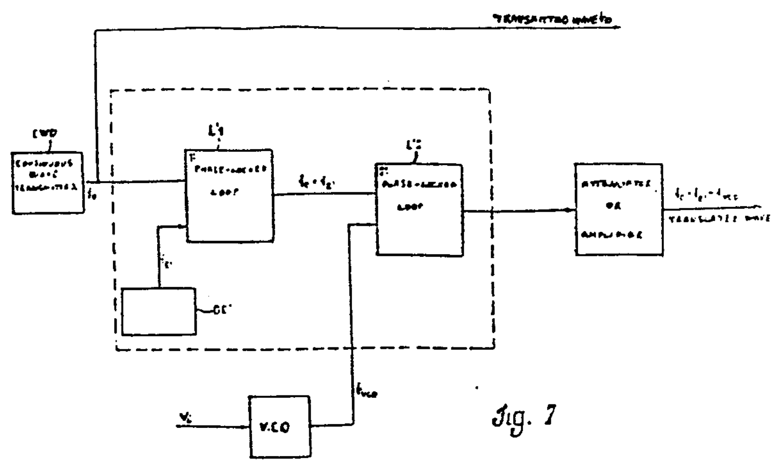


Fig. 7

EP 0 005 127 A2

Croydon Printing Company Ltd.

0005127

"Improvement in systems of frequency translation of frequency-modulated signals".

## DESCRIPTION

This invention concerns the improvement of frequency translation systems for frequency-modulated signals. In particular the invention concerns a system of frequency translation of frequency-modulated signals in a continuous manner above and below a pre-determined frequency, during the excursion the translation being able to assume a value of zero.

In the known technique this displacement is effected by single side band modulation as will be shown later. This solution presents notable disadvantages.

This invention makes use of two phase-locked circuits placed in cascade; this solution overcomes all the disadvantages associated with the techniques now known.

The system of this invention will now be described in its form of realization at present preferred, given as an illustrative but not limiting claim, with reference to the attached figures listed below:

Figure 1 shows an amplitude/frequency diagram illustrating the problem which that invention sets out to solve.

Figure 2 shows the block diagram of an ideal suppress ed-carrier modulator.

Figure 3 shows the output spectra of an ideal suppressed-carrier modulator.

Figure 4 shows the ideal arrangement for a single side-band modulator.

Figure 5 shows the typical arrangement of a phase-locked loop.

Figure 6 shows the block diagram of two phase-locked loops placed in series in accordance with this invention.

Figure 7 shows a method of using the circuit arrangement of Figure 6 for the simulation od C.W. or persistent doppler radar returns.

The problem of the translation of frequency-modulated spectra is considered from a frequency-modulated carrier $f_o$ (Figure 1). Suppose that it is desired to effect a translation of $\pm \Delta f$. Then there will be two spectra F1, F2, centred respectively an $f_o + \Delta f$ and $f_o - \Delta f$.

A method at present in use to obtain the translation described above is the suppressed carrier method of modulation.

It is required to obtain the product of the wave:

$$l_1 = l_{1a} + l_{1b} + l_{1c}$$

which corresponds to the spectrum $f_{1a}$, $f_{1b}$, $f_{1c}$, and of the wave: $l_2$

which corresponds to a frequency $f_2$, which corresponds to the displacement $\Delta$ f which it is desired to obtain.

At the output of the product circuit, shown in Figure 2, a wave

$$l_u = l_{1a} \cdot l_2 + l_{1b} \cdot l_2 + l_{1c} \cdot l_2$$

is obtained . Its spectrum is shown in Figure 3 and does not require special illustrations.

Thus two spectra are obtained similar to that with which we started symmetrically placed with respect to it and separated from one another by a distance (in frequency) of $2f_2$.

With the known techniques one of the translated spectra can be suppressed, so obtaining the desired one translated with respect to the original one by the frequency $f_2$. An example of a circuit of this type is given in Figure 4. With reference to this figure the signals $l_1$, $l_2$ are fed to the first product circuit 10, and after phase displacement of $\pi/2$ in the phase shifters PS1 and PS2 to a second product circuit 11.

The outputs of circuits 10 and 11 are fed to a summer 12 at the output of which there is the required side band $l_u$.

This technique presents various disadvantages mainly connected with the facts that:

a) the operation of multiplication of the product circuits 10, 11 is not perfect since

- it does not succeed in completely suppressing the starting spectrum, and

-. there is the appearance of undesired lines (products of intermodulation)

b) the operation of phase displacement in the circuits PS1 and PS2 and of the summing in circuit 12 is not perfect and therefore the undesired spectrum cannot be completely suppressed.

Further, it may be observed that the translation may not be effected to right or to left of the desired spectrum with the same device, but only in one of the two directions. Further the amplitude of the undesired lines depends also on the amplitude of the input waves.

Another known method for frequency translation of a spectrum FM consists of the use of a phase-locked loop arrangement as shown in Figure 5.

If it is desired to translate a wave of frequency $f_o$, and the spectrum associated with it by an amount:

$$f = f_D$$

in this case, a loop locked to the frequency $f_{IF}$ is necessarily equal to $f_D$ and the frequency of the output wave is translated with respect to $f_o$ by an amount $f_D$ ($f_o + f_D$ or $f_o - f_D$) above or below according to whether the locking is made to the higher or lower image frequency.

So that the frequency modulation of $f_o$ is transferred to the output wave of the V.C.O. virtually unchanged, it is necessary for the loop to have a bandwidth equivalent to $B_{eq}$, such that if $f_m$ is the maximum modulating frequency:

$$\frac{B_{eq}}{2} > (2 \div 3)\, f_m$$

and that the damping $\xi$ is:

$$\xi > 2 - 3$$

On the other hand it is known that frequency translations of $\Delta f <$ about 5 $B_{eq}$ cannot be obtained by a phase-locked loop due to the difficulties encoundered in sufficiently attenuating the alternating signals present at the output of the phase comparator. (Regarding this see F.M. Gardner "Phase Lock Techniques", J. Wiley and W. Manasse Witch "Frequency Synthesizers").

As the bandwidth of the loop has to be small with respect to the frequency displacement that it is desired to obtain, there is also a limitation in the bandwidth of the noise cancelled by the loop. This method, therefore, can only be used when the frequency displacement which it is desired to obtain is large with respect to the maximum modulating frequency $f_m$. It should also be noted that with a device of this type frequency displacements may only be obtained to right or to left of the starting frequency.

The solution adopted in the present invention is shown schematically in Figure 6. As may be seen in Figure 6 there are two wide band phase locked loops L1, L2. The first phase-locked loop L1 receives the frequency $f_o$ and the reference frequency $f_R$ coming from a reference oscillator OR and is arranged to lock to the frequency sum $f_o + f_r$. The second phase-locked loop L2 receives the frequency sum $f_o + f_r$ coming from the first loop and a frequency $f_{VCO}$ coming from a variable frequency oscillator VCO controlled for example by a control voltage Vi.

The phase-locked loop L2 is made to lock on to the difference frequency between the two input frequencies ($f_o + f_R$) and $f_{VCO}$.

Therefore at the output there will be a frequency $F = (f_o + f_R) - f_{VCO}$. The difference $f_R - f_{VCO}$ (positive or negative) determines the displacement high or low of the system output frequency F with respect to the input frequency $f_o$.

Therefore, if for example $f_R = f_{VCO}$ then $F = f_o$; if $f_{VCO} > f_R$ then $F < f_o$ and vice versa. Consequently the frequency F can be made to vary, by means of the control voltage Vi, above and below the input frequency $f_o$, being able also to assume the same value as $f_o$. This is shown diagramatically in Figure 6a.

The device in this invention of using two phase-locked loops placed in series allows:

a) the use of a reference frequencies $f_R$ and $f_{VCO}$ sufficiently high with respect to $f_m$, the maximum modulating frequency of $f_o$, that the ripple from the phase comparators is at a high enough frequency to be easily attenuated by the low pass filter of the loop.

b) the use of a sufficiently wide band phase locked loop to allow the modulation FM of the input wave $f_o$ to be found on the output wave F

c) the cancellation of the circuit noise and that of the V.C.O. due to the wide bandwidth so that the frequency noise at the output is practically only that present on the input wave.

d) the displacing of the output frequency F, by means of a displacement of $f_{VCO}$ of loop 12 at high velocity due to the large bandwidth.

e) the continuity of displacements of the frequency F whether they are positive, zero or negative with respect to $f_o$, which was not possible by means of the known techniques.

f) the elimination of the carrier wave and side band at the output which are features of the side band modulation system, and not this suppression in a way that depends on the circuit characteristics.

The arrangement of this invention finds particular application in the simulation of continuous wave doppler radar returns.

An example of this application will now be given.

It is known that the wave reflected from a target $f_R$ undergoes a displacement of frequency (doppler effect) with respect to the transmitted wave $f_o$. This is given by:

$$f_D = \frac{2 V_r}{\lambda} = 2 V_r \frac{f_o}{c}$$

where

$V_r$ = velocity of approach or departure

$\lambda$ = wavelenght

c = velocity of light

The simulation in the laboratory of the reflected wave $f_r$ from a specified target, starting from a transmitted wave $f_o$, is equally known as an extremely useful result.

The relative doppler displacement is given by:

$$f_D / f_o = \frac{2 V_r}{c}$$

which for

$V_r$ = 150 m/sec

c = $3.10^8$ m/sec

gives the value

$$f_D/f_o = \frac{2 \cdot 150}{3 \cdot 10^8} \approx 10^{-6}$$

While the relative width of the frequency spectrum by which the transmitted wave may be affected, both for intentional modulation and for undersired modulation (noise) is:

$$\frac{\Delta f_s}{f_o} \approx 10^{-5}$$

It is thus clear that with these values of $f_D/f_o$ and $f_s/f_o$ the methods used up to now run into difficulties.

With the arrangement of this invention, shown in Figure 7, a spectrum FM may be obtained similar to that of the starting spectrum and translated in frequency (positively or negatively) by any amount whatever, even a very small amount and at the limit zero.

As shown in Figure 7 there is a continuous wave transmitter CWO which trans mits a frequency modulated wave $f_o$.

The first phase-locked loop L1 with its relative reference oscillator OR, as already described, produces a wave of frequency $f_o + f_r$ which is applied to the second phase-locked loop L2 together with the wave $f_{VCO}$ from the VCO controlled by the voltage Vi.

The output of the second phase-locked loop L2 is applied to an

amplifier/attenuator at the output of which the desired translated wave $f_o + f_R - f_{VCO}$ is obtained.

The invention has been described in relation to a preferred form of realization at the present time, and it will be understood that in practice variations and modifications can be made to it without taking it outside the present industrial patent rights.

CLAIMS

1. System of frequency translation for frequency modulated signals in a continuous mode above and below a pre-fixed frequency, the said translation being able to assume a value of zero during its excursion and characterized by the fact that it includes: a source of frequency modulated signal whose frequency must be translated; a first phase-locked loop to which the said signal source is applied together with a signal from a reference oscillator, the arrangement being such that the first phase-locked loop is locked to a conversion frequency higher (lower) than the said source signal; the output of the said first phase-locked loop being applied to a second phase-locked loop together with a variable frequency signal produced by an oscillator with a controllable frequency, the arrangement being such that the said second phase-locked loop is locked to a conversion frequency lower (higher) than that of the said first phase-locked loop so that the output frequency of the said second phase-locked loop is greater than, equal to or less than the frequency of the said signal source according to the frequency of the said controllable frequency oscillator.

2. System of frequency translation for frequency modulated signals in accordance with claim 1, and substantially as illustrated and described with reference to the Figure 7 of the attached drawings.

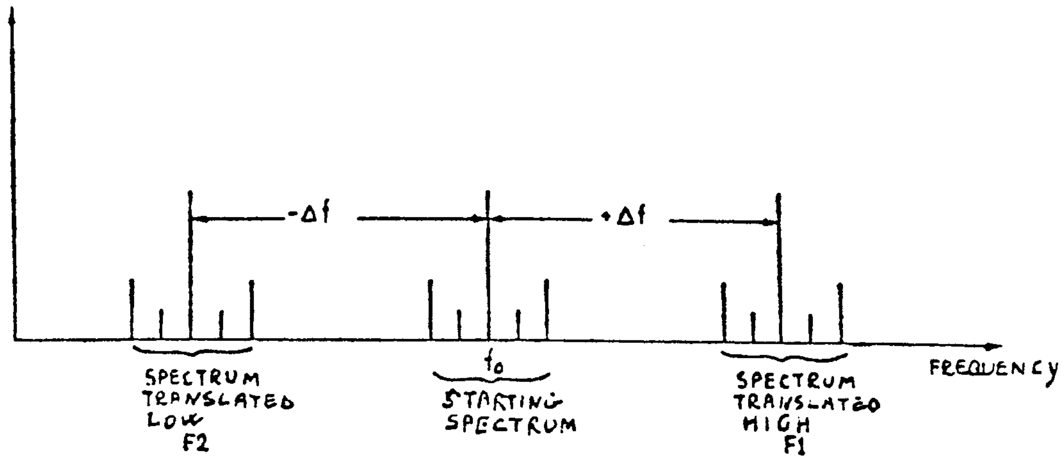
-Δf
+Δf
$f_0$
FREQUENCY
SPECTRUM TRANSLATED LOW F2
STARTING SPECTRUM
SPECTRUM TRANSLATED HIGH F1

Fig. 1

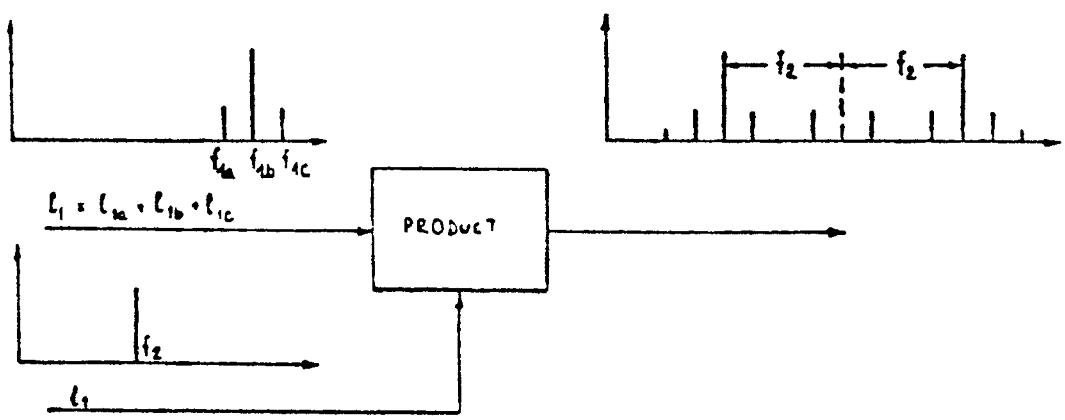
$f_{1a}$ $f_{1b}$ $f_{1c}$
$e_1 = e_{1a} + e_{1b} + e_{1c}$
PRODUCT
$f_2$
$e_1$
$f_2$ $f_2$

Fig. 2

0005127

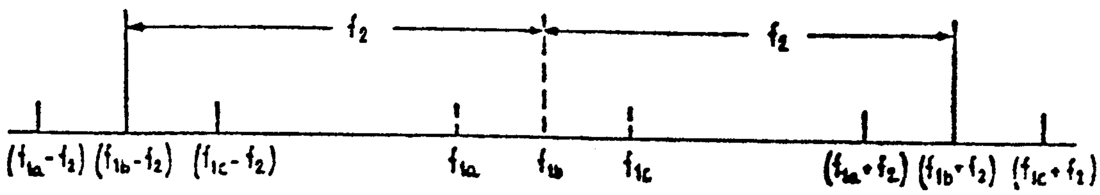


Fig. 3

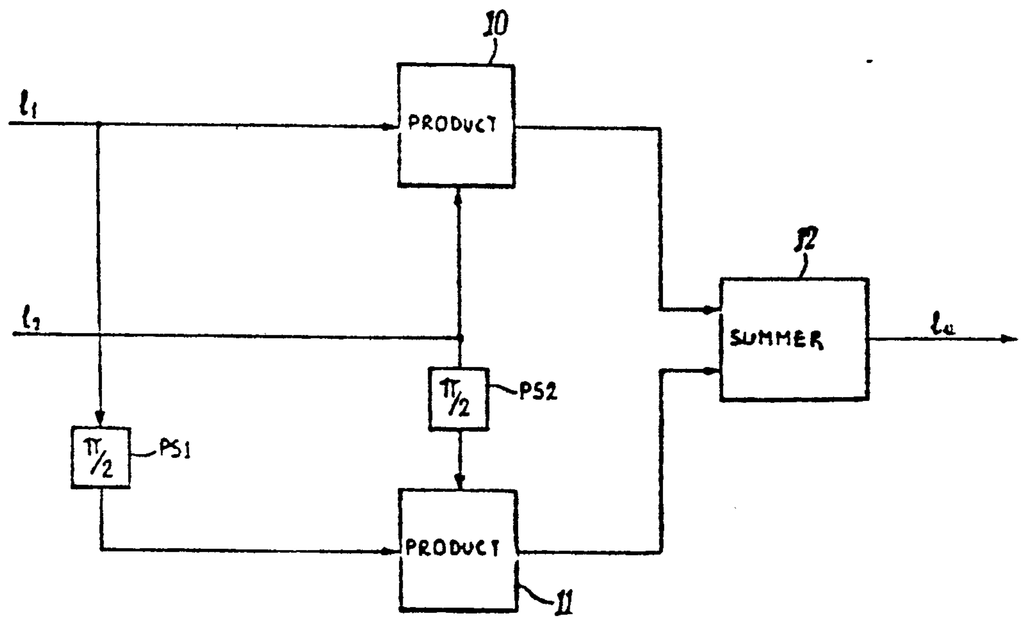


Fig. 4

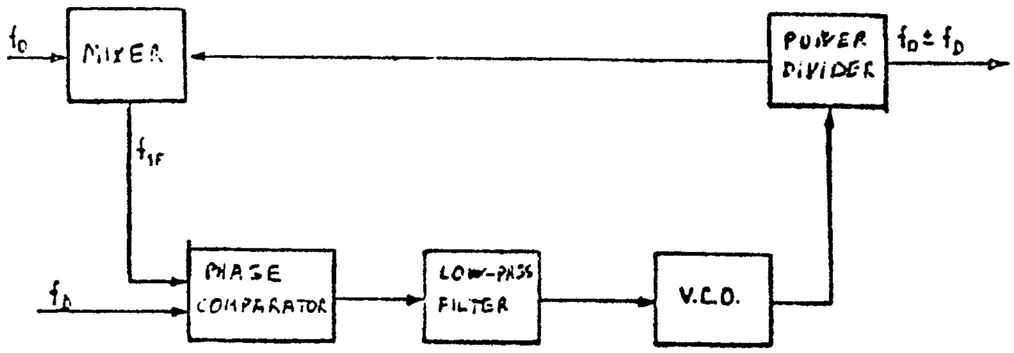


Fig. 5

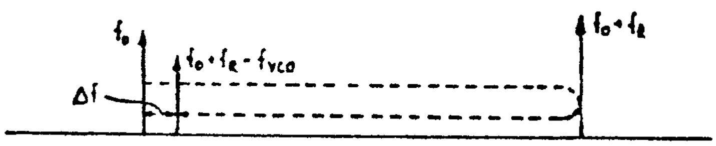


Fig. 6a

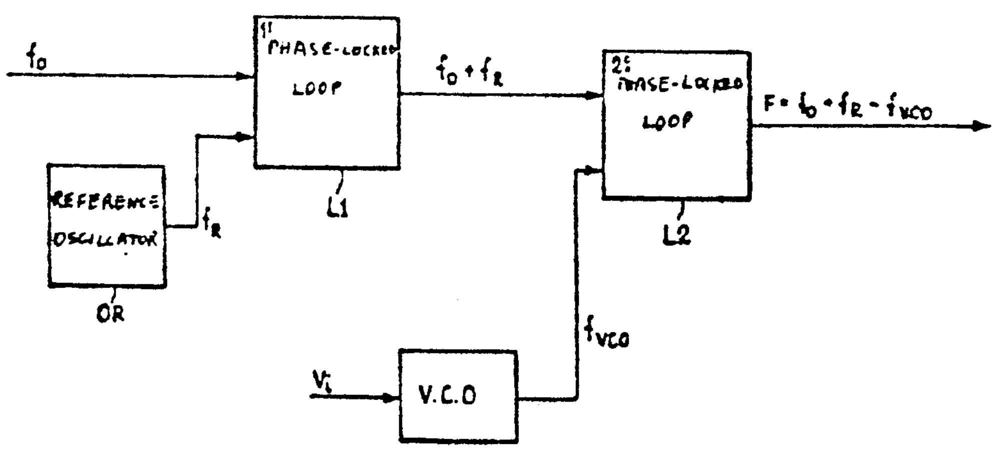


Fig. 6

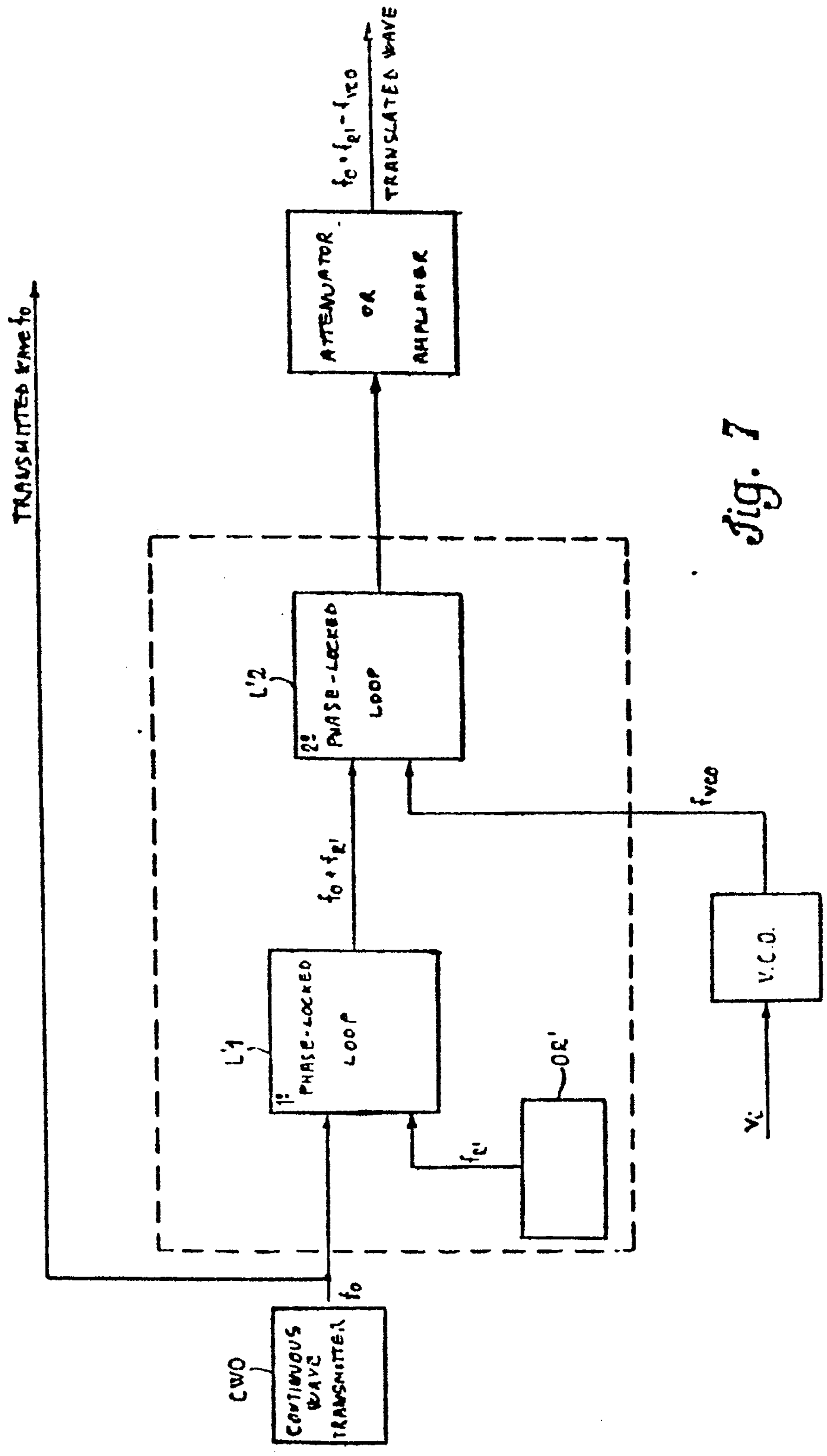
TRANSMITTED WAVE fo
CWO
CONTINUOUS WAVE TRANSMITTER
fo
L'1
1°
PHASE-LOCKED LOOP
OR'
fr'
fo + fr'
L'2
2°
PHASE-LOCKED LOOP
fvco
V.C.O.
vi
ATTENUATOR OR AMPLIFIER
fo + fr' - fvco
TRANSLATED WAVE

Fig. 7